Europäisches Patentamt

European Patent Office

Office européen des brevets

(19)

(11) **EP 1 615 063 A1**

(12) **EUROPÄISCHE PATENTANMELDUNG**

(43) Veröffentlichungstag:
**11.01.2006 Patentblatt 2006/02**

(51) Int Cl.:
*G02B 21/00* *(2006.01)*     *G03F 7/20* *(2006.01)*
*G03F 1/00* *(2006.01)*      *G02B 5/30* *(2006.01)*

(21) Anmeldenummer: 05014398.1

(22) Anmeldetag: **02.07.2005**

(84) Benannte Vertragsstaaten:
**AT BE BG CH CY CZ DE DK EE ES FI FR GB GR
HU IE IS IT LI LT LU LV MC NL PL PT RO SE SI
SK TR**
Benannte Erstreckungsstaaten:
**AL BA HR MK YU**

(30) Priorität: **08.07.2004 DE 102004033602**

(71) Anmelder: **Carl Zeiss SMS GmbH
07745 Jena (DE)**

(72) Erfinder:
• **Greif-Wüstenbecker, Jörn
07743 Jena (DE)**
• **Strössner, Ulrich
07745 Jena (DE)**
• **Totzeck, Michael
73525 Schwäbisch Gmünd (DE)**

(54) **Abbildungssystem zur Emulation hochaperturiger Scannersysteme**

(57)     Die vorliegende Erfindung betrifft ein optisches Abbildungssystem für Inspektionsmikroskope, mit denen Lithographiemasken insbesondere durch die Emulation hochaperturiger Scannersysteme auf Fehler geprüft werden können.

Das erfindungsgemäße Abbildungssystem zur Emulation hochaperturiger Scannersysteme besteht aus einer Abbildungsoptik, einem Detektor und einer Auswerteeinheit, bei dem mindestens ein polarisationswirksames optisches Bauelement im Abbildungsstrahlengang zur Selektion unterschiedlicher Polarisationsanteile der Abbildungsstrahlung wahlweise angeordnet ist, ein optisches Bauelement mit Intensitätsschwächungsfunktion in den Abbildungsstrahlengang eingebracht werden kann, Abbilder der Maske und/oder Probe für unterschiedlich polarisierte Strahlungsanteile vom Detektor aufgenommen und an die Auswerteeinheit zur Weiterverarbeitung weitergeleitet werden.

Mit der vorgeschlagenen Lösung ist es insbesondere möglich Lithographiemasken, trotz immer kleiner werdenden Strukturen und immer höheren abbildungsseitigen NA der Abbildungssysteme, mit Hilfe von Inspektionsmikroskopen mit großen Vergrößerungen auf Defekte zu untersuchen. Es können reale Abbildungen der Steppersysteme durch Emulation der auftretenden Vektoreffekte erzeugt werden.

Kombination 1

Polarisator mit
unterschiedlicher
Orientierung

Ortsabhängiger
Rotator

Graufilter

Kombination 2

Ortsabhängiger
Rotator

Linearer
Polarisator

Graufilter

**Figur 2**

EP 1 615 063 A1

**Beschreibung**

Die vorliegende Erfindung betrifft ein optisches Abbildungssystem für Inspektionsmikroskope, mit denen Lithographiemasken insbesondere durch die Emulation hochaperturiger Scannersysteme für die Halbleiterlithographie auf Fehler geprüft werden können.

Immer kleiner werdende Objektstrukturgrößen erfordern immer größere abbildungsseitige numerische Aperturen von Scannersystemen. Durch die damit immer auch größer werdenden Einfallswinkel kommt es allerdings zu den sogenannten Vektoreffekten, bei denen tangential- und radial-polarisierte Strahlungsanteile unterschiedliche Intensitätsverläufe aufweisen. Es zeigt sich, dass die Strahlungsanteile, die senkrecht zu der durch Einfallsrichtung und Flächennormale des Substrates aufgespannten Einfallsebene schwingen (s-polarisiert), interferiert und somit einen stärkeren Kontrast erzeugen, als die parallel dazu schwingenden Strahlungsanteile (p-polarisiert). Diese sogenannten Vektoreffekte führen zu einem sinkenden Kontrast für p-polarisierte Anteile der Strahlung und dadurch zu einem sinkenden Gesamtkontrast bei Scannersystemen mit großen abbildungsseitigen numerischen Aperturen.

Für die weitere Beschreibung wird folgende Definition zugrunde gelegt: Licht ist eine transversale elektromagnetische Welle, dessen Feld senkrecht zur Ausbreitungsrichtung schwingt. Licht dessen Feldvektor E nur in einer Richtung schwingt, heißt linear polarisiertes Licht. Die Polarisationsrichtung ist dabei die Richtung in die der Feldvektor E schwingt. Der einfallende und der reflektierte Strahl definiert die sogenannte, senkrecht zur Grenzfläche der beiden Medien stehende, Einfallsebene. Licht, dessen Polarisationsebene senkrecht zur Einfallsebene liegt, heißt s-polarisiertes und Licht, dessen Polarisationsebene parallel zur Einfallsebene liegt, p-polarisiertes Licht.

Tangentiale (s-)Polarisation liegt vor, wenn das Licht in der Pupille eines optischen Systems linear polarisiert ist und sich die Polarisationsrichtung dabei über die Pupille ändert, so dass die Polarisationsrichtung in jedem Ort der Pupille tangential zur optischen Achse (senkrecht zum Radiusvektor) steht. Radial (p-)Polarisation liegt hingegen vor, wenn die Polarisationsrichtung in jedem Ort der Pupille radial zur optischen Achse (parallel zum Radiusvektor) steht.

Die aktuelle Roadmap der Halbleiterindustrie favorisiert den Einsatz von Immersionssystemen zur Herstellung von Waferstrukturen kleiner als 65nm. Durch das Aufbringen einer Immersionsflüssigkeit auf dem Wafer werden abbildungsseitige numerische Aperturen NA > 1 erreicht, so dass bei gleicher Wellenlänge kleinere Strukturen abgebildet uns somit erzeugt werden können. Da die Maskenstrukturen somit im Bereich der Abbildungswellenlänge liegen, werden auch die Polarisationseffekte durch die Masken immer dominanter.

Diese p-polarisierten Strahlungsanteile werden bei der Abbildung einer Lithographiemaske durch Scannersysteme anders abgebildet als durch ein Inspektionsmikroskop. Durch die vergrößerte Abbildung der Lithographiemaske auf eine CCD-Matrix ist die abbildungsseitige numerische Apertur hierbei extrem gering, so dass Vektoreffekte nicht auftreten. Wird nun ein Mikroskop dazu verwendet Lithographiemasken durch die Emulation eines Scannersystems zu inspizieren, so sind die auftretenden Vektoreffekte zur Begutachtung der Lithographiemaske unbedingt erforderlich, da ein reales Abbild des Scannersystems sonst nicht emuliert werden kann.

Bei den nach dem Stand der Technik bekannten Inspektionsmikroskopen ist die Berücksichtigung von Vektoreffekten bisher nicht implementiert, da die numerischen Aperturen der verwendeten Abbildungssysteme < 1 sind und Vektoreffekte somit zu einem untergeordneten Fehler führen.

Die Analyse von Defekten im Maskenherstellungsprozess wird damit bei kleineren Strukturen immer wichtiger. Zu Analyse von Maskendefekten hinsichtlich Printability ist seit 10 Jahren das AIMS™ (Aerial Imaging Measurement System) der Carl Zeiss SMS GmbH im Markt etabliert. Dabei wird ein kleiner Bereich der Maske (Defektort) mit den gleichen Beleuchtungs- und Abbildungsbedingungen (Wellenlänge, NA, Sigma, Polarisation) wie im lithographischen Scanner beleuchtet und abgebildet. Im Gegensatz zum Scanner wird jedoch das von der Maske erzeugte Luftbild auf eine CCD Kamera vergrößert. Die Kamera sieht das gleiche Bild wie der Resist auf dem Wafer. Somit kann ohne aufwändige Testprints das Luftbild analysiert werden. Durch Aufnahme einer Fokusreihe bekommt man zusätzliche Informationen zur Analyse des lithographischen Prozessfensters.

Während der Lithographiescanner die Maskenstruktur verkleinert auf den zu belichtenden Träger abbildet, wird bei der Maskeninspektion hingegen die Struktur vergrößert auf einen Detektor abgebildet. Bei beiden Systemen ist die maskenseitige Numerische Apertur gleich.

Nach Stand der Technik spielen die Abbildungsseitigen Unterschiede zwischen Scanner und dem Emulationsmikroskop eine untergeordnete Rolle. Bei steigender abbildungsseitiger numerischer Apertur des Scanners steigt dieser Unterschied und kann nicht mehr vernachlässigt werden. Dieser in der Scannerabbildung auftretende Effekt wird Vektoreffekt genannt.

Der vorliegenden Erfindung liegt die Aufgabe zugrunde, eine Lösung für Lithographiemasken Inspektionsmikroskope zur Scanneremulation zu entwickeln, die es ermöglicht auch die Abbildungen von Lithographie-Scannersystemen mit einer abbildungsseitigen numerischen Apertur größer als 1 zu emulieren.

Erfindungsgemäß wird die Aufgabe durch die Merkmale der unabhängigen Ansprüche gelöst. Bevorzugte Weiterbildungen und Ausgestaltungen sind Gegenstand der abhängigen Ansprüche.

Mit der vorgeschlagenen Lösung ist es möglich Lithographiemasken, trotz immer kleiner werdenden Strukturen und immer höheren abbildungsseitigen NA der Abbildungssysteme, mit Hilfe von Inspektionsmikroskopen mit großen Vergrößerungen auf Defekte zu untersuchen. Es können reale Abbildungen der Scannersysteme durch Emulation der auftretenden Vektoreffekte erzeugt werden.

Die vorgeschlagene Lösung ist auch in anderen optischen Systemen anwendbar, bei denen die Eigenschaften einer hochaperturigen Abbildungsoptik durch eine niederaperturige Abbildungsoptik emuliert werden sollen, um entsprechende Effekte zu betrachten und/oder zu berücksichtigen.

Die Erfindung wird nachfolgend anhand von Ausführungsbeispielen näher beschrieben. Dazu zeigen

Figur 1: für eine numerische Apertur von 1,2 die Transmission des Abschwächers sowie Orientierung des Polarisators der 3 Bauele mente,

Figur 2: zwei mögliche Kombinationen für die Anordnung der 3 Bauele mente,

Figur 3: für eine numerischen Apertur von 1,2 die Transmission und Rotation für ein Beispiel mit zwei identischen Bauteilen und

Figur 4: für eine numerischen Apertur von 1,2 die Transmission und Rotation für ein Beispiel mit drei identischen Bauteilen.

Das erfindungsgemäße mikroskopische Abbildungssystem zur Emulation hochaperturiger Abbildungssysteme, insbesondere zur Maskeninspektion, besteht aus einer Abbildungsoptik, einem Detektor und einer Auswerteeinheit. Dabei werden polarisationswirksame optische Bauelemente zur Erzeugung unterschiedlicher Polarisationszustände der Beleuchtungsstrahlung im Beleuchtungsstrahlengang und/oder im Abbildungsstrahlengang zur Selektion der unterschiedlichen Polarisationsanteile der Abbildungsstrahlung wahlweise angeordnet. Ein optisches Bauelement mit polarisationsabhängiger Intensitätsschwächungsfunktion kann dabei in den Abbildungsstrahlengang eingebracht werden. Vom Detektor werden Abbilder der Maske und/oder Probe für unterschiedlich polarisierte Strahlungsanteile aufgenommen. Im Anschluss werden von einer Auswerteeinheit die Abbilder für unterschiedlich polarisierte Strahlungsanteile zu einem Gesamtbild zusammengefasst. Dies geschieht beispielsweise durch Addition deren Intensitätsverteilungen.

Das 2-dimensionale E-Feld in der Pupille erzeugt aufgrund der hohen numerischen Apertur im Bildfeld des Scanners eine 3-dimensionale E-Feld-Verteilung mit Komponenten in x-, y- und z-Richtung. Im Scanner interferieren die x-, y- und z-Komponenten nicht miteinander, denn sie stehen jeweils orthogonal.

Die polarisationsoptischen Bauelemente bestehen dabei entweder aus einem Polarisator mit sich über die Fläche ändernder Orientierung, einem ortsabhängigen Abschwächer und einem ortsabhängigen Rotator oder aus einem ortsabhängigen Rotator, einem ortsabhängigen Abschwächer und einem linearen Polarisator.

Die polarisationsoptischen Bauelement selektieren die Anteile des E-Feldes, die im Abbild des hochaperturigen Systems ein in einer bestimmten Richtung orientiertes E-Feld erzeugen.

Bei der hier beschriebenen Lösung werden z. B. 3 polarisationsoptische Bauelemente wechselweise pupillennah bzw. in der Nähe einer konjugierten Bildebene des Inspektionsmikroskops eingebracht. Sie sind so gestaltet, dass sie aus dem 2-dimensionalen E-Feld in der Pupille die Anteile selektieren, die in der Bildebene des Scanners ein E-Feld in x-, y- oder z-Richtung erzeugen. Diese werden nacheinander in eine Ebene nahe der Abbildungspupille des Inspektionsmikroskops eingebracht. Vorzugsweise werden die Komponenten des E-Feldes noch parallel innerhalb der Bildfeldebene für ihre Interferenzfähigkeit ausgerichtet.

Jedes dieser 3 Bauelemente besteht in diesem Fall aus einem linearen Polarisator, dessen Polarisationsrichtung sich über den Ort geeignet ändert, einem ortsabhängigen, polarisationsunabhängigen Abschwächer und einem ortsabhängigen Rotator, der die verschieden orientierten Stahlungsanteile parallel richtet.

Dabei liegen die E-Feldrichtungen der von den polarisationsoptischen Bauelementen selektierten Anteile der E-Felder vorzugsweise parallel und senkrecht zur optischen Achse, oder die Projektion von 2 oder 3 dieser Richtungen auf die optische Achse hat den gleichen Betrag.

In diesem Ausführungsbeispiel muss der Rotator dabei nach dem Polarisator angeordnet sein, der Abschwächer kann vor, zwischen oder hinter den beiden anderen Bauelementen stehen.

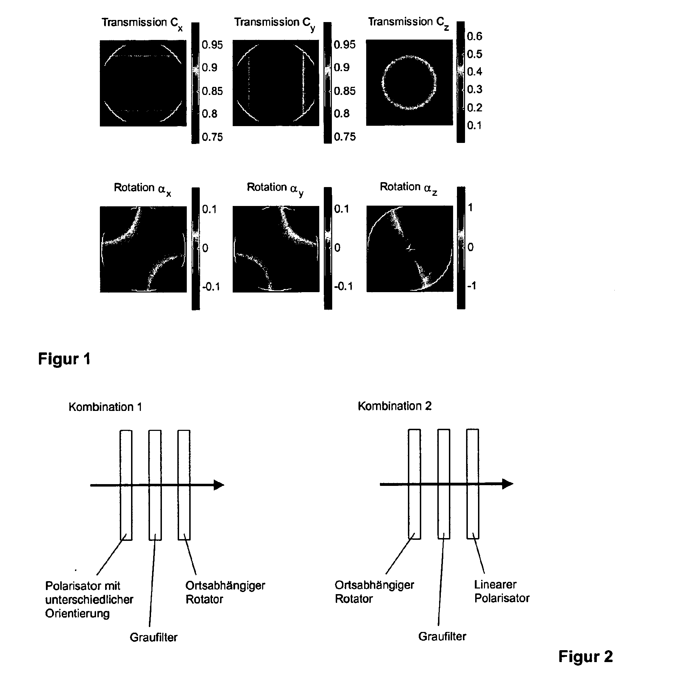

**Figur 1** zeigt für das Beispiel einer Numerischen Apertur von 1,2 in der oberen Zeile für die 3 Bauelemente die Transmission des Abschwächers über die Pupille und in der unteren Zeile die Orientierung des Polarisators in rad, die zugleich auch die Rotation des Rotators darstellt.

Die x- und y-Komponente werden durch einen entlang der x- bzw. y-Achse gedämpften x- und y-Polarisator wiedergegeben. Die Verdrehung, bzw. der notwendige Rotationswinkel sind außerordentlich klein. Beide Elemente können daher zumindest für diese NA in guter Näherung bereits durch einen linearen Polarisator in Kombination mit einem Graufilter realisiert werden.

In einer anderen Anordnung zur Realisierung dieser 3 Bauelemente wird ein ortsabhängiger Rotator, gefolgt von einem linearen Polarisator verwendet. Der Abschwächer kann wieder vor, zwischen oder hinter den beiden anderen Bauelementen stehen. Dazu zeigt **Figur 2** zwei Kombinationen für die mögliche Anordnung der 3 Bauelemente.

Die z-Komponente wird in Kombination 1 aus einem zur Mitte hin gedämpften Radialpolarisator erzeugt, Der folgende Rotator dreht die radiale Polarisation wieder parallel, so dass alle Pupillenpunkte miteinander interferieren können. In Kombination 2 besteht der Polarisator dagegen lediglich aus einem nach außen hin gedämpften Linearpolarisator.

Mit jedem der 3 Bauelemente wird mindestens ein Bild aufgenommen. Diese 3 Bilder werden anschließend von der Auswerteeinheit weiter verarbeitet, beispielsweise addiert. Damit können die Vektoreffekte exakt emuliert werden.

In einer vereinfachten Anordnung kann man für die x- und y- Komponente die Rotation und die Variation der Orientierung des Polarisators, die sehr klein ist vernachlässigen. Die Fehler, die aus dieser Vernachlässigung resultieren, können durch die zusätzliche Aufnahme von Bildern für die Diagonalkomponenten (1/sqrt(2)*(x+y) und 1/sqrt(2)*(x-y)) minimiert werden.

In einer anderen Anordnung werden die polarisationsoptischen Bauelemente so ausgebildet, dass sie nicht die E-Feld-Komponenten in x-, y- und z- sondern in a-, b- und c-Richtung selektieren. Dabei müssen a, b und c je paarweise orthogonal zueinander stehen. Sie können aus x, y und z durch eine beliebige 3-dimensionale Rotation hervorgehen.

In einer besonders vorteilhaften Ausgestaltung werden zwei oder drei identische polarisationsoptische Bauelemente verwendet, die auf verschiedene Winkelstellungen gedreht werden können. Beispielsweise können a, b und c als

$$a = \begin{pmatrix} 1 \\ 0 \\ 0 \end{pmatrix}, \ b = \begin{pmatrix} 0 \\ \sqrt{1/2} \\ \sqrt{1/2} \end{pmatrix}, \ c = \begin{pmatrix} 0 \\ -\sqrt{1/2} \\ \sqrt{1/2} \end{pmatrix}$$

oder

$$a = \begin{pmatrix} \sqrt{2/3} \\ 0 \\ \sqrt{1/3} \end{pmatrix}, \ b = \begin{pmatrix} -\sqrt{1/6} \\ \sqrt{1/2} \\ \sqrt{1/3} \end{pmatrix}, \ c = \begin{pmatrix} -\sqrt{1/6} \\ -\sqrt{1/2} \\ \sqrt{1/3} \end{pmatrix}$$

gewählt werden.

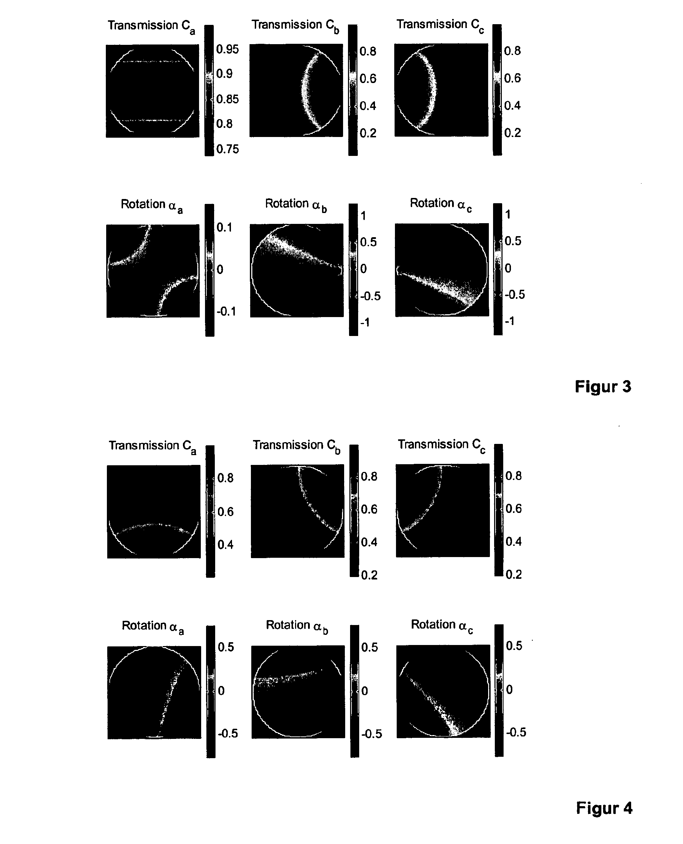

Die **Figuren 3** und **4** zeigen für diese Wahl von a, b und c und das Beispiel einer numerischen Apertur von 1,2 die Transmission und Rotation.

Im ersten und zweiten Fall sind 2 Bauteile identisch, im letzten sind alle 3 identisch. Es genügt also ein Bauelement, das drehbar angeordnet ist.

Treten Fehler auf, weil die Wirkung der Bauelemente von der idealen abweicht, können diese verringert werden, indem Bauelemente für mehr als 3 Richtungen eingesetzt werden. Beispielsweise kann dies bei der letzten Wahl von a, b und c einfach implementiert werden, indem das eine Bauteil auf mehr als 3 verschiedene Winkel gedreht wird. Durch das Aufnehmen von mehr als drei Abbildern und die entsprechende Wahl der Richtungen der selektierten E-Felder können vorhandene Fehler verringert werden.

Mit dem erfindungsgemäßen Abbildungssystem zur Emulation hochaperturiger Scannersysteme wird eine Lösung zur Verfügung gestellt, bei der zur Emulation von Vektoreffekten nur noch ein optisches Bauelement erforderlich ist, welches in verschiedenen Winkelstellungen im Strahlengang positioniert wird.

**Patentansprüche**

**1.**  Abbildungssystem zur Emulation hochaperturiger Scannersysteme bestehend aus einer Abbildungsoptik, einem Detektor und einer Auswerteeinheit, bei dem mindestens ein polarisationswirksames und/oder intensitätsschwächendes optisches Bauelement im Abbildungsstrahlengang zur Selektion unterschiedlicher Polarisationsanteile der Abbildungsstrahlung wahlweise angeordnet ist, Abbilder der Maske und/oder Probe für unterschiedlich polarisierte Strahlungsanteile vom Detektor aufgenommen und an die Auswerteeinheit zur Weiterverarbeitung weitergeleitet werden.

2.  Abbildungssystem nach Anspruch 1, bei dem das polarisationsoptische Bauelement aus einem Polarisator mit räumlich veränderlicher Orientierung, einem ortsabhängigen Abschwächer und einem ortsabhängigen Rotator besteht.

3.  Abbildungssystem nach mindestens einem der Ansprüche 1 und 2, bei dem das polarisationsoptische Bauelement aus einem ortsabhängigen Rotator, einem ortsabhängigen Abschwächer und einem linearen Polarisator besteht.

4.  Abbildungssystem nach mindestens einem der vorgenannten Ansprüche, bei dem das polarisationswirksames und/oder intensitätsschwächendes optisches Bauelement pupillennah bzw. in der Nähe einer konjugierten Bildebene angeordnet werden kann.

5.  Abbildungssystem nach mindestens einem der vorgenannten Ansprüche, bei dem das polarisationsoptische Bauelement die Anteile des E-Feldes selektiert, die im Abbild des hochaperturigen Systems ein in einer bestimmten Richtung orientiertes E-Feld erzeugen.

6.  Abbildungssystem nach mindestens einem der vorgenannten Ansprüche, bei dem mehrere polarisationsoptische Bauelemente verwendet werden, deren selektierte E-Feld-Richtungen im Abbild des hochaperturigen Systems jeweils orthogonal zueinander stehen, wobei vorzugsweise drei polarisationsoptische Bauelemente Verwendung finden.

7.  Abbildungssystem nach Anspruch 5, bei dem die E-Feld-Richtungen der von den polarisationsoptischen Bauelementen selektierten Anteile der E-Felder vorzugsweise parallel und senkrecht zur optischen Achse liegen, oder die Projektion von 2 oder 3 dieser Richtungen auf die optische Achse den gleichen Betrag hat.

8.  Abbildungssystem nach mindestens einem der vorgenannten Ansprüche, bei dem ein oder zwei verschiedene polarisationsoptische Bauelemente verwendet werden, von denen mindestens eines auf verschiedene Winkelstellungen gedreht wird.

9.  Abbildungssystem nach mindestens einem der vorgenannten Ansprüche, bei dem die E-Feld-Richtungen der von den polarisationsoptischen Bauelementen selektierten Anteile der E-Felder so gewählt sind, dass bei mindestens einer dieser Richtungen die Rotation vernachlässigt werden kann.

10. Abbildungssystem nach Anspruch 8, bei dem mehr als drei Abbilder aufgenommen werden, bei denen die E-Feld-Richtungen der von den polarisationsoptischen Bauelementen selektierten Anteile der E-Felder so gewählt sind, dass sich vorhandene Fehler verringern.

Transmission $C_x$

Transmission $C_y$

Transmission $C_z$

Rotation $\alpha_x$

Rotation $\alpha_y$

Rotation $\alpha_z$

**Figur 1**

Kombination 1

Kombination 2

Polarisator mit
unterschiedlicher
Orientierung

Ortsabhängiger
Rotator

Graufilter

Ortsabhängiger
Rotator

Linearer
Polarisator

Graufilter

**Figur 2**

Transmission $C_a$

Transmission $C_b$

Transmission $C_c$

Rotation $\alpha_a$

Rotation $\alpha_b$

Rotation $\alpha_c$

**Figur 3**

Transmission $C_a$

Transmission $C_b$

Transmission $C_c$

Rotation $\alpha_a$

Rotation $\alpha_b$

Rotation $\alpha_c$

**Figur 4**

**Europäisches Patentamt**

# EUROPÄISCHER RECHERCHENBERICHT

Nummer der Anmeldung

EP 05 01 4398

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | US 6 657 736 B1 (FINAROV MOSHE ET AL) 2. Dezember 2003 (2003-12-02) * Spalte 8, Zeile 19 - Spalte 10, Zeile 54; Abbildung 3 * * Spalte 13, Zeile 51 - Spalte 14, Zeile 12 * ----- | 1,4,6,8 | G02B21/00 G03F7/20 G03F1/00 G02B5/30 |
| X | US 2004/085539 A1 (OPSAL JON) 6. Mai 2004 (2004-05-06) * Absatz [0029] - Absatz [0034]; Abbildung 2 * ----- | 1 | |

**RECHERCHIERTE SACHGEBIETE (Int.Cl.7)**

G02B
G03F

Der vorliegende Recherchenbericht wurde für alle Patentansprüche erstellt

| Recherchenort | Abschlußdatum der Recherche | Prüfer |
|---|---|---|
| Berlin | 14. Oktober 2005 | Andreassen, J |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 05 01 4398

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

14-10-2005

| Im Recherchenbericht angeführtes Patentdokument | Datum der Veröffentlichung | Mitglied(er) der Patentfamilie | Datum der Veröffentlichung |
|---|---|---|---|
| US 6657736 B1 | 02-12-2003 | IL 130874 A | 01-12-2002 |
| US 2004085539 A1 | 06-05-2004 | US 2003043375 A1 | 06-03-2003 |

EPO FORM P0461

Für nähere Einzelheiten zu diesem Anhang : siehe Amtsblatt des Europäischen Patentamts, Nr.12/82